# EUROPEAN PATENT APPLICATION

(11) **EP 4 752 427 A1**
(43) Date of publication of application: **03.06.2026**
(21) Application number: 25218133.4
(22) Date of filing: 24.11.2025
(51) Int. Cl.: F21K 9/64, F21V 7/30, F21V 9/38, H01S 5/00

(54) **OPTICAL SYSTEM FOR LIGHTING**

(30) Priority: 29.11.2024 JP 2024208740
(71) Applicant: NICHIA CORPORATION, Tokushima 774-8601 (JP)
(72) Inventor: KUNIMUNE, Teppei, Anan-shi, Tokushima, 774-8601 (JP); SAWANOBORI, Takuya, Anan-shi, Tokushima, 774-8601 (JP)
(74) Representative: Betten & Resch

(57) **Abstract**

An optical system for lighting according to an embodiment includes: a laser light source configured to emit first light having a peak wavelength in a range of 420 nm to 480 nm; a wavelength conversion member including a phosphor layer including two or more types of phosphor particles, part of the first light being incident on the wavelength conversion member, from which second light exits; and a reflective-transmissive member configured to transmit part of the first light and reflect part of the second light as third light, in which a transmittance of the reflective-transmissive member is less than 85% for light having a wavelength of 450 nm, and is 20% or less for light having a wavelength of 550 nm.

## Description

### CROSS-REFERENCE TO RELATED APPLICATION

This application claims priority to Japanese Patent Application No. 2024-208740, filed on November 29, 2024, the disclosure of which is hereby incorporated by reference in its entirety.

### TECHNICAL FIELD

The embodiments relate to an optical system for lighting.

### BACKGROUND

A lighting device using a laser light source is disclosed (See, for example, Japanese Patent Publication No. 2015-501062). The lighting device uses, for example, a wavelength conversion member in which a phosphor layer is formed on a base. Lighting is light that illuminates an object to help easily recognize the object, and is evaluated differently from applications such as in displays and projectors that show the color of light from a light source. Therefore, for the lighting device, "color rendering property", which is a criterion for how fidelity the lighting shows the color of the object, is an important index. The lighting device is expected to improve its color rendering properties.

### SUMMARY

The embodiments provide an optical system for lighting of which color rendering properties can be improved.

An optical system for lighting according to an embodiment of the present disclosure includes a laser light source, a wavelength conversion member, and a reflective-transmissive member. The laser light source emits first light having a peak wavelength in a range of 420 nm to 480 nm. The wavelength conversion member includes a phosphor layer including two or more types of phosphor particles. Part of the first light is incident on the wavelength conversion member, from which second light exits. The reflective-transmissive member transmits part of the first light and reflects the second light as third light. A transmittance of the reflective-transmissive member is less than 85% for light having a wavelength of 450 nm, and is 20% or less for light having a wavelength of 550 nm.

An optical system for lighting according to an embodiment of the present disclosure includes a laser light source, a wavelength conversion member, and a reflective-transmissive member. The laser light source emits first light having a peak wavelength in a range of 420 nm to 480 nm. The wavelength conversion member includes a phosphor layer including two or more types of phosphor particles. The first light is incident on the wavelength conversion member, from which second light exits. The reflective-transmissive member reflects part of the second light as third light. A transmittance of the reflective-transmissive member is less than 85% for light having a wavelength of 450 nm, and is 20% or less for light having a wavelength of 550 nm.

According to an embodiment of the present invention, an optical system for lighting can be provided of which color rendering properties can be improved.

### BRIEF DESCRIPTION OF DRAWINGS

FIG. 1 is a schematic view exemplifying an optical system for lighting according to a first embodiment.
FIG. 2 is a schematic cross-sectional view exemplifying a wavelength conversion member included in the optical system for lighting according to the first embodiment.
FIG. 3 is a schematic view exemplifying an optical system for lighting according to a second embodiment.
FIG. 4 is a diagram illustrating characteristics of reflective-transmissive members used in Example 1, Example 2, Comparative Example 1, and Comparative Example 2.
FIG. 5 shows conditions and results of Example 1, Example 2, Comparative Example 1, and Comparative Example 2.

### DETAILED DESCRIPTION

Embodiments of the present invention are described below with reference to the drawings. The drawings are schematic and conceptual, and are exaggerated and simplified as appropriate. Further, even for the same constituent elements, dimensional ratios, positional relationships, numbers, and the like may not exactly match between the drawings. As a cross-sectional view, an end view illustrating only a cut surface may be illustrated.

### First Embodiment

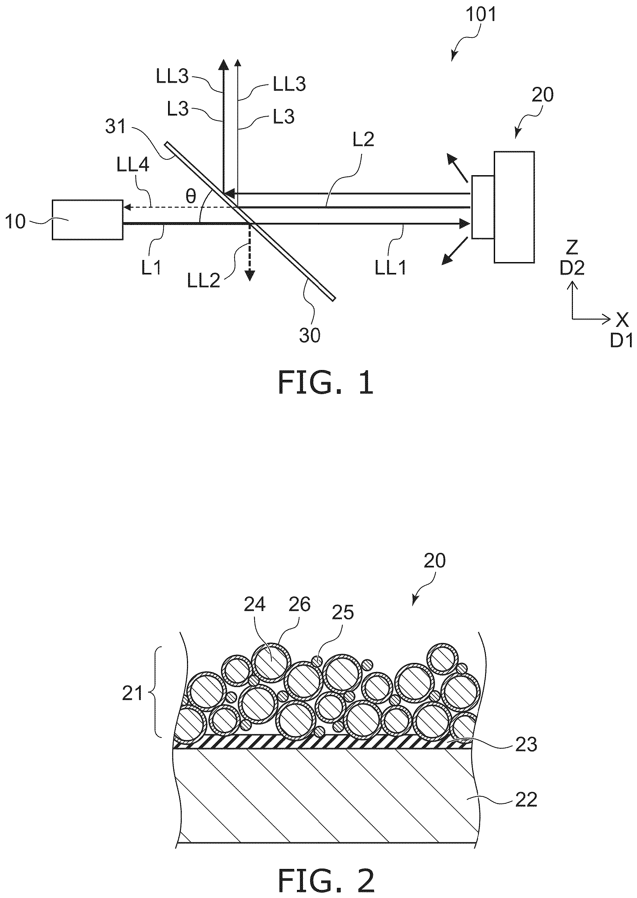

FIG. 1 is a schematic view exemplifying an optical system for lighting according to a first embodiment.

As illustrated in FIG. 1, an optical system for lighting 101 according to the first embodiment includes a laser light source 10, a wavelength conversion member 20, and a reflective-transmissive member 30.

One direction perpendicular to an X-axis direction is defined as a Z-axis direction. A first direction D1 is, for example, the X-axis direction. A second direction D2 is, for example, the Z-axis direction.

The laser light source 10 emits first light L1 having a peak wavelength in a range of 420 nm to 480 nm. The first light L1 includes, for example, a first component LL1 and a second component LL2.

The wavelength conversion member 20 includes a phosphor layer 21 including two or more types of phosphor particles 24 as described later. Part of the first light L1 is incident on the wavelength conversion member 20, from which second light L2 exits. The second light L2 has, for example, a third component LL3 and a fourth component LL4.

The reflective-transmissive member 30 transmits part of the first light L1 and reflects the second light L2 as third light L3. The transmittance of the reflective-transmissive member 30 is less than 85% for light having a wavelength of 450 nm. The transmittance of the reflective-transmissive member 30 is 20% or less for light having a wavelength of 550 nm. The reflective-transmissive member 30 is formed of, for example, the same member as a dichroic mirror.

The laser light source 10 is disposed so as to face the wavelength conversion member 20. The reflective-transmissive member 30 is disposed between the laser light source 10 and the wavelength conversion member 20. The laser light source 10, the wavelength conversion member 20, and the reflective-transmissive member 30 are arranged along the first direction D1, for example.

For example, the laser light source 10 emits the first light L1 in the first direction D1. The wavelength conversion member 20 allows the second light L2 to exit toward a direction opposite to the first direction D1, for example. The reflective-transmissive member 30 reflects the second light L2 in the second direction D2 as the third light L3, for example.

The phosphor particles 24 included in the wavelength conversion member 20 are excited by incident light, and emit light having a wavelength longer than that of the incident light.

In the optical system for lighting 101 according to the first embodiment, the laser light source 10 emits the first light L1 toward the reflective-transmissive member 30. The first component LL1, which is part of the first light L1, is transmitted through the reflective-transmissive member 30. The transmitted first component LL1 is incident on the wavelength conversion member 20. The first component LL1 incident on the wavelength conversion member 20 is converted by the wavelength conversion member 20 into the second light L2 having a longer wavelength than the incident light. From the wavelength conversion member 20, the second light L2 subjected to wavelength conversion exits. The second light L2 exits back toward the reflective-transmissive member 30. The third component LL3, which is part of the second light L2, is reflected by the reflective-transmissive member 30 as the third light L3. The fourth component LL4, which is part of the second light L2, is transmitted through the reflective-transmissive member 30.

A reference example is conceivable in which the transmittance of the reflective-transmissive member 30 is 85% or more for light having a wavelength of 450 nm, and is less than 20% for light having a wavelength of 550 nm (a so-called dichroic mirror). In this reference example, the blue wavelength does not pass through the reflective-transmissive member, and therefore, improvement of the color rendering properties cannot be achieved. In the optical system for lighting 101 according to the first embodiment, the transmittance of the reflective-transmissive member 30 is less than 85% for light having a wavelength of 450 nm, and is 20% or less for light having a wavelength of 550 nm. The optical system for lighting 101 according to the first embodiment can improve the color rendering properties.

FIG. 2 is a schematic cross-sectional view exemplifying the wavelength conversion member included in the optical system for lighting according to the first embodiment.

As illustrated in FIG. 2, the wavelength conversion member 20 includes a base 22, a dielectric multilayer film 23, and the phosphor layer 21.

The base 22 is disposed on the lower side of the phosphor layer 21. The base 22 has light reflectivity and heat dissipation properties. The base 22 may be transmissive. A material of the base 22 may be metal such as gold, silver, copper, iron, nickel, chromium, aluminum, titanium, tantalum, tungsten, cobalt, ruthenium, tin, zinc, or lead, or an alloy thereof. The aluminum alloy may be, for example, an alloy of aluminum and copper, silver, or a platinum group metal such as platinum.

The dielectric multilayer film 23 is provided between the base 22 and the phosphor layer 21. The dielectric multilayer film 23 reflects light incident from the phosphor layer 21 side. As the dielectric multilayer film 23, a distributed Bragg reflector (DBR) film, for example, can be used. The dielectric multilayer film 23 can reflect light efficiently.

A dielectric of the dielectric multilayer film 23 may be, for example, an oxide or a nitride containing at least one element selected from the group consisting of silicon (Si), titanium (Ti), zirconium (Zr), niobium (Nb), tantalum (Ta), and aluminum (Al).

The thickness of the dielectric multilayer film 23 may be, for example, in a range of 0.1 µm to several tens of µm, in a range of 0.1 µm to 10 µm, or in a range of 0.3 µm to 7 µm.

The wavelength conversion member 20 may include a single layer formed of metal or a multilayer film formed of metal. The metal may be gold, silver, copper, iron, nickel, chromium, aluminum, titanium, tantalum, tungsten, cobalt, ruthenium, tin, zinc, lead, or other metal, or an alloy thereof. For example, the aluminum alloy may be an alloy of aluminum and copper, silver, or a platinum group metal such as platinum.

The phosphor particles 24 contain an activator. The concentration of the activator may be 5 mol% or less.

The phosphor particles 24 may be two or more types selected from an yttrium aluminum garnet (YAG)-based phosphor activated with cerium as an activator, a nitrogen-containing calcium aluminosilicate (CaO-Al₂O₃-SiO₂) phosphor activated with europium and/or chromium as an activator, a CASN-based phosphor activated with europium, a SCASN-based phosphor, a silicate ((Sr, Ba)₂SiO₄) phosphor, an α-sialon phosphor, and a β-sialon phosphor.

For the phosphor particles 24, a material having a relatively high heat resistance and less likely to be deteriorated by excitation light is used. The phosphor particles 24 may be a G-LAG-based phosphor, a YAG-based phosphor, a LAG-based phosphor, a CASN-based phosphor, a SCASN-based phosphor, or the like. Examples of the YAG-based phosphor include those in which at least part of Y is replaced with Tb or at least part of Y is replaced with Lu. The YAG-based phosphor may also contain Gd, Ga, or the like in its composition. A preferable composition of the phosphor particles 24 contains (Y, Gd, Lu)₃(Al, Ga)₅O₁₂:Ce.

The phosphor particles 24 contain CaAlSiN₃:Eu and (Sr, Ca) AlSiNs:Eu.

The diameter of the phosphor particles 24 may be 5 µm or less.

From the wavelength conversion member 20 including the phosphor particles 24, the second light L2 exits. A color rendering index Ra of the white light of the third light L3 reflected by the reflective-transmissive member 30 is 80 or more.

The phosphor layer 21 includes oxide particles 25 adhering to the phosphor particles 24. The material of the oxide particles 25 is different from the material of a coating film 26. In a case in which the material of the coating film 26 is silicon oxide, the material of the oxide particles 25 is other than silicon oxide.

The oxide particles 25 may be formed of at least one selected from the group consisting of Al₂O₃, ZrO₂, HfO₂, TiO₂, ZnO, Ta₂O₅, Nb₂O₅, In₂O₃, and SnO₂. The oxide particles 25 adhere to the phosphor particles 24 and bond the phosphor particles 24 to each other after firing.

For the oxide particles 25, a material having a thermal expansion coefficient close to that of the phosphor particles 24 or a material having low light absorption may be used. The material suitable for the oxide particles 25 is aluminum oxide, for example.

The phosphor layer 21 includes the coating film 26 continuously coating the surfaces of the phosphor particles 24 and the oxide particles 25. The coating film 26 coats each of the phosphor particles 24. The oxide particles 25 are disposed in the coating film 26.

The coating film 26 contains an inorganic material. Further, the coating film 26 contains a silicon oxide. Examples of the silicon oxide include SiO₂ and SiO_{1.5}.

An extinction coefficient of the coating film 26 is less than 1.0 × 10⁻⁵. The extinction coefficient means an imaginary part of a complex refractive index in a visible light region. The extinction coefficient can be measured using a spectroscopic ellipsometer (for example, VASE: manufactured by J.A. Woollam Co.).

As a coating film formation method, the coating film 26 containing SiO₂ or the like is formed on the phosphor particles 24 and the oxide particles 25 disposed on the base 22 or the reflective film by an ALD device. After the film formation, the coating film 26 is firmly fixed to the base 22 together with the phosphor particles 24 and the oxide particles 25.

The total thickness of the phosphor layer 21 may be 30 to 50 µm. With such a configuration, a light extraction efficiency can be improved.

The reflective-transmissive member 30 includes a first surface 31 on which the first light L1 is incident. An angle θ between the first surface 31 and the first direction D1 from the laser light source 10 toward the wavelength conversion member 20 may be in a range of 30 degrees to 60 degrees. The laser light source 10 emits blue light.

### Second Embodiment

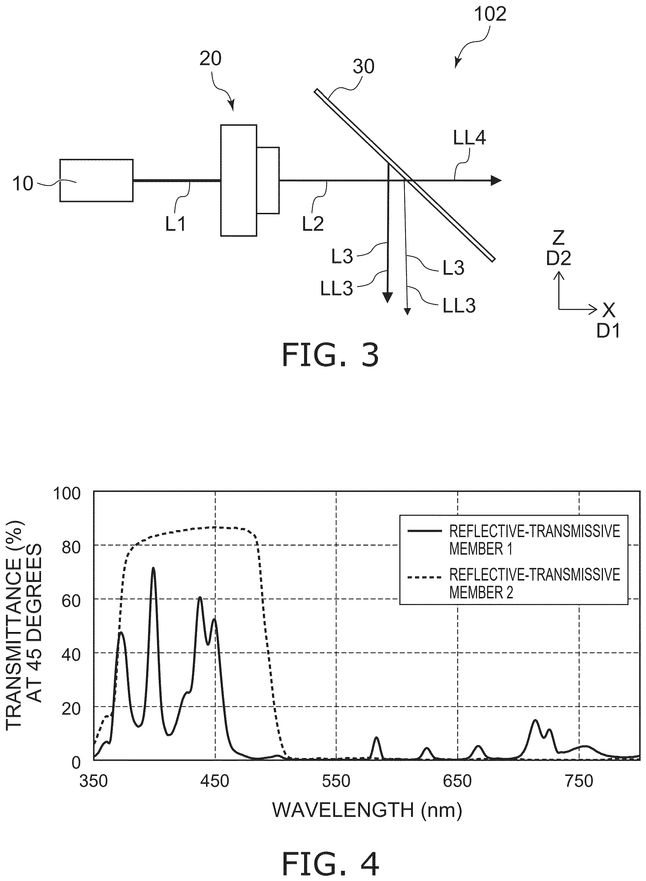

FIG. 3 is a schematic view exemplifying an optical system for lighting according to a second embodiment.

An optical system for lighting 102 according to the second embodiment differs from the optical system for lighting 101 according to the first embodiment in the locations of the wavelength conversion member 20 and the reflective-transmissive member 30. The configuration of the optical system for lighting 102 except for this difference may be the same as or similar to the configuration of the optical system for lighting 101.

The laser light source 10 is disposed so as to face the reflective-transmissive member 30. The wavelength conversion member 20 is disposed between the laser light source 10 and the reflective-transmissive member 30. The laser light source 10, the wavelength conversion member 20, and the reflective-transmissive member 30 are arranged along the first direction D1, for example.

From the wavelength conversion member 20, the second light L2 including the third component LL3 and the fourth component LL4 exits.

The reflective-transmissive member 30 reflects the third component LL3, which is part of the second light L2, as the third light L3. The transmittance of the reflective-transmissive member 30 is less than 85% for light having a wavelength of 450 nm, and is 20% or less for light having a wavelength of 550 nm.

The base 22 may be a transmissive substrate. The base 22 may be a sapphire substrate or the like. The dielectric multilayer film 23 may be absent or may be provided, and transmits the first light L1 as the blue light.

For example, the laser light source 10 emits the first light L1 in the first direction D1. From the wavelength conversion member 20, the second light L2 exits, for example, in the first direction D1. The reflective-transmissive member 30 reflects the second light L2 toward a direction opposite to the second direction D2, for example.

In the optical system for lighting 102 according to the second embodiment, the laser light source 10 emits the first light L1 toward the wavelength conversion member 20. The emitted first light L1 is incident on the wavelength conversion member 20. The first light L1 incident on the wavelength conversion member 20 is converted by the wavelength conversion member 20 into the second light L2 including light having a longer wavelength than the incident light. From the wavelength conversion member 20, the second light L2 exits toward the reflective-transmissive member 30. The third component LL3, which is part of the second light L2, is reflected by the reflective-transmissive member 30 as the third light L3. The fourth component LL4, which is part of the second light L2, is transmitted through the reflective-transmissive member 30. According to the embodiment, the optical system for lighting 102 can be provided of which the color rendering properties can be improved.

### Examples

The optical systems for lighting 101 and 102 according to the embodiments will be specifically described hereinafter using examples. However, the optical systems for lighting according to the embodiments are not limited to these examples.

### Example 1

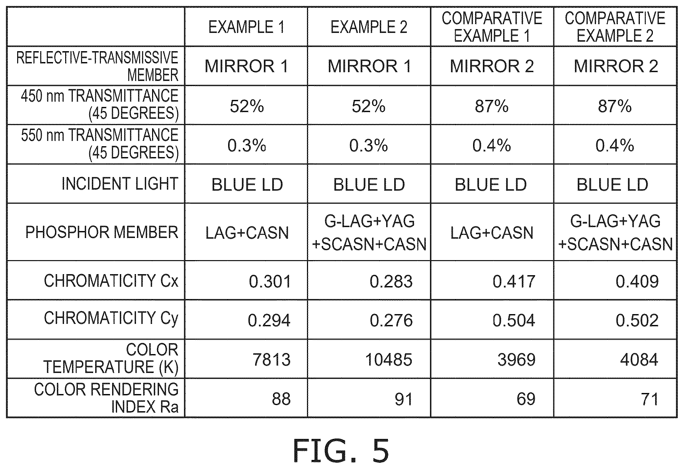

A laser light source that emits the first light having a peak wavelength in a range of 420 nm to 480 nm was prepared. In addition, a reflective-transmissive member was prepared. As the reflective-transmissive member, a reflective-transmissive member 1 (mirror 1) having the characteristics shown in FIG. 5 was prepared. As shown in FIG. 5, the transmittance of the reflective-transmissive member 1 is 52% for light having a wavelength of 450 nm, and is 0.3% for light having a wavelength of 550 nm.

The method for producing the wavelength conversion member is as follows.

A base formed of copper having reflectivity was prepared. Then, an aluminum film and a DBR film were formed on the base. A printing resin was prepared by mixing an acrylic resin (KC-1300 manufactured by Kyoeisha Chemical Co., Ltd.), terpineol as a solvent, nano-alumina particles (Alu C) as the oxide particles 25, LAG-based phosphor particles (median diameter: 22.2 µm, activator Ce: 0.055 mol), and CASN-based phosphor particles (median diameter: 16.7 µm, activator Eu: 0.005 mol). The diameter of the phosphor particles was measured by a laser diffraction method. The blending weight ratio in the printing resin was set to 100/20/192/48/3.6 for solvent/acrylic resin/LAG-based phosphor particles/CASN-based phosphor particles/nano-alumina particles.

The base was print-coated with the printing resin through a printing mask. Then, the base was dried in an oven at 150°C for 0.5 hours, and further dried at 180°C for 0.5 hours to volatilize the solvent. Further, the acrylic resin was decomposed and volatilized by firing the base in an oven at 250°C for 10 hours. Then, ozone cleaning was performed to completely remove any remaining traces of the acrylic resin.

Subsequently, a film of SiO₂ was formed as a coating film at 200°C by using an ALD device. At this time, the thickness of the film formed by ALD was 0.1 µm. Thus, the wavelength conversion member was obtained.

The laser light source, the wavelength conversion member, and the reflective-transmissive member were disposed as illustrated in FIG. 1. That is, the laser light source was disposed so as to face the reflective-transmissive member and the wavelength conversion member. The reflective-transmissive member was disposed between the laser light source and the wavelength conversion member. The angle between the first surface and the first direction was 45 degrees. In this manner, an optical system for lighting according to Example 1 was obtained. Then, the color rendering index Ra of the third light, which is the light obtained when the second light from the wavelength conversion member is reflected by the reflective-transmissive member, was measured. The color rendering index Ra was measured with an integrating sphere and a multi-channel spectrometer.

### Example 2

As Example 2, G-LAG-based phosphor particles (median diameter: 23.4 µm, activator Ce: 0.028 mol), YAG-based phosphor particles (median diameter: 19.7 µm, activator Ce: 0.065 mol), SCASN-based phosphor particles (median diameter: 21.2 µm, activator Eu: 0.014 mol), and CASN-based phosphor particles (median diameter: 16.7 µm, activator Eu: 0.005 mol) as phosphor particles were mixed to prepare a wavelength conversion member. The blending weight ratio in the printing resin was set to 100/20/157.5/17.5/5/10/2.85 for solvent/acrylic resin/G-LAG-based phosphor particles/YAG-based phosphor particles/SCASN-based phosphor particles/CASN-based phosphor particles/nano-alumina particles. Other conditions were the same as or similar to those in Example 1. Thus, the optical system for lighting in Example 2 was obtained. Then, the color rendering index Ra of the third light, which is the light obtained after the second light from the wavelength conversion member is reflected by the reflective-transmissive member, was measured.

### Comparative Example 1

As Comparative Example 1, a reflective-transmissive member 2 (mirror 2) having the characteristics shown in FIG. 5 was prepared as a reflective-transmissive member. As shown in FIG. 5, the transmittance of the reflective-transmissive member 2 is 87% for light having a wavelength of 450 nm, and is 0.4% for light having a wavelength of 550 nm. The reflective-transmissive member 2 is so called a dichroic mirror. Other conditions were the same as or similar to those in Example 1. In this way, the optical system for lighting in Comparative Example 1 was obtained. Then, the color rendering index Ra of the third light, which is the light obtained after the second light from the wavelength conversion member is reflected by the reflective-transmissive member, was measured.

### Comparative Example 2

As Comparative Example 2, a reflective-transmissive member 2 (mirror 2) having the characteristics shown in FIG. 5 was prepared as a reflective-transmissive member. As shown in FIG. 5, the transmittance of the reflective-transmissive member 2 is 87% for light having a wavelength of 450 nm, and is 0.4% for light having a wavelength of 550 nm. The reflective-transmissive member 2 is so called a dichroic mirror. Other conditions were the same as or similar to those in Example 2. In this way, the optical system for lighting in Comparative Example 2 was obtained. Then, the color rendering index Ra of the third light, which is the light obtained after the second light from the wavelength conversion member is reflected by the reflective-transmissive member, was measured.

FIG. 5 shows the conditions and the results of Example 1, Example 2, Comparative Example 1, and Comparative Example 2.

The color rendering index Ra in Example 1 was 88. The color rendering index Ra in Example 2 was 91. The color rendering index Ra in Comparative Example 1 was 69. The color rendering index Ra in Comparative Example 2 was 71. The color rendering index Ra in Example 1 and Example 2 using the reflective-transmissive member 1 was higher than the color rendering index Ra in Comparative Example 1 and Comparative Example 2 using the reflective-transmissive member 2. In the optical systems for lighting in Example 1 and Example 2, the color rendering properties can be improved.

According to the embodiments, an optical system for lighting can be provided of which color rendering properties can be improved.

The optical systems for lighting according to the embodiments may be intended for laser lighting.

Each of the above-described embodiments and modified examples is an example embodying the present invention, and the present invention is not limited to these embodiments and modified examples. For example, in each of the above-described embodiments and modified examples, those in which some of the components or steps are added, omitted, or changed are also included in the present invention. Each of the above-described embodiments and modified examples can be implemented in combination with each other.

## Claims

1. An optical system for lighting, comprising:
a laser light source configured to emit first light having a peak wavelength in a range of 420 nm to 480 nm;
a wavelength conversion member comprising a phosphor layer including two or more types of phosphor particles, the wavelength conversion member on which part of the first light is incident and from which second light exits; and
a reflective-transmissive member configured to transmit part of the first light and reflect part of the second light as third light, wherein
a transmittance of the reflective-transmissive member is less than 85% for light having a wavelength of 450 nm, and is 20% or less for light having a wavelength of 550 nm.

2. The optical system for lighting according to claim 1, wherein the phosphor layer comprises a coating film continuously coating surfaces of the phosphor particles.

3. The optical system for lighting according to any of the preceding claims, wherein a color rendering index Ra of white light of the third light is 80 or more.

4. The optical system for lighting according to any of the preceding claims, wherein the phosphor particles contain CaAlSiN₃:Eu and (Sr, Ca)AlSiN₃:Eu.

5. An optical system for lighting according to any of the preceding claims, further comprising a base disposed on a lower side of the phosphor layer, wherein
the wavelength conversion member comprises a dielectric multilayer film, and
the dielectric multilayer film is provided between the base and the phosphor layer.

6. The optical system for lighting according to any of claims 2 to 5, wherein the coating film contains an inorganic material.

7. The optical system for lighting according to any of claims 2 to 6, wherein the coating film contains a silicon oxide.

8. The optical system for lighting according to any of claims 2 to 7, wherein an extinction coefficient of the coating film is less than 1.0 × 10⁻⁵.

9. The optical system for lighting according to any of claims 2 to 8, wherein
the phosphor layer includes oxide particles adhering to the phosphor particles, and
a material of the oxide particles is different from a material of the coating film.

10. The optical system for lighting according to claim 9, wherein the oxide particles are formed of at least one selected from the group consisting of Al₂O₃, ZrO₂, HfO₂, TiO₂, ZnO, Ta₂O₅, Nb₂O₅, In₂O₃, and SnO₂.

11. The optical system for lighting according to any of the preceding claims, wherein a diameter of the phosphor particles is 5 µm or less.

12. The optical system for lighting according to any of the preceding claims, wherein
the phosphor particles contain an activator, and
a concentration of the activator is 5 mol% or less.

13. The optical system for lighting according to any of the preceding claims, wherein
the reflective-transmissive member has a first surface on which the first light is incident, and
an angle between the first surface and a first direction from the laser light source toward the wavelength conversion member is in a range of 30 degrees to 60 degrees.

14. An optical system for lighting, comprising:
a laser light source configured to emit first light having a peak wavelength in a range of 420 nm to 480 nm;
a wavelength conversion member comprising a phosphor layer including two or more types of phosphor particles, the wavelength conversion member on which the first light is incident and from which second light exits; and
a reflective-transmissive member configured to reflect part of the second light as third light, wherein
a transmittance of the reflective-transmissive member is less than 85% for light having a wavelength of 450 nm, and is 20% or less for light having a wavelength of 550 nm.
